# FASCICULE DE BREVET EUROPEEN

(11) **EP 3 484 047 B1**
(45) Date de publication et mention de la délivrance du brevet: **02.12.2020**
(21) Numéro de dépôt: 18204637.5
(22) Date de dépôt: 06.11.2018
(51) Int. Cl.: H02S 40/22

(54) **SYSTEME D'ENERGIE SOLAIRE PHOTOVOLTAIQUE A GAIN AMELIORE**
FOTOVOLTAIK-SONNENENERGIESYSTEM MIT VERBESSERTER AUSBEUTE
PHOTOVOLTAIC SOLAR ENERGY SYSTEM WITH IMPROVED GAIN

(30) Priorité: 09.11.2017 FR 1760540
(43) Date de publication de la demande: 15.05.2019
(73) Titulaire: COMMISSARIAT À L'ÉNERGIE ATOMIQUE ET AUX ÉNERGIES ALTERNATIVES, 75015 Paris (FR)
(72) Inventeur: PILAT, Eric, 73100 Brison-Saint-Innocent (FR); SAYRITUPAC VERA, Jose Ruben, 73000 Chambéry (FR)
(74) Mandataire: Brevalex

(56) Documents cités:
- US-A1- 2010 212 720
- US-A1- 2017 063 295
- US-A1- 2017 257 059

## Description

### DOMAINE TECHNIQUE

La présente invention se rapporte au domaine de l'énergie solaire photovoltaïque, et en particulier à des systèmes comprenant des cellules solaires photovoltaïques bifaciales.

L'invention s'applique en particulier à des systèmes destinés à être installés au sol ou sur des toitures de bâtiments.

### ETAT DE LA TECHNIQUE ANTERIEURE

De l'art antérieur, il est connu de réaliser des systèmes comprenant des cellules solaires photovoltaïques de nature bifaciale, ces cellules étant regroupées au sein de panneaux photovoltaïques. L'intérêt de telles cellules réside dans le fait qu'elles définissent en face avant une surface d'absorption directe destinée à absorber une énergie de rayonnement solaire, et, en face arrière, une surface d'absorption indirecte également destinée à absorber une énergie de rayonnement solaire.

Plusieurs réalisations ont déjà été envisagées pour l'obtention de ce type de système comme par exemple celui montré dans le document US 2017/0063295 A1. Il est par exemple aussi connu le document CN 204993212, dans lequel il est décrit des systèmes équipés de panneaux comprenant des cellules photovoltaïques bifaciales, prolongés vers le bas par des réflecteurs. Chaque réflecteur est incliné pour permettre l'irradiation de la surface arrière des cellules d'un autre système situé plus en avant.

Ce type de conception présente néanmoins de nombreux inconvénients, au premier rang lesquels la nécessité de faire coopérer un système avec au moins un autre système situé en avant, afin d'illuminer sa surface arrière d'absorption indirecte. L'utilisation de ce type de système demeure ainsi cantonnée à des centrales solaires présentant une pluralité de rangées de systèmes. De plus, la distance entre chaque rangée devient un paramètre dépendant de ce besoin en irradiation de la surface arrière par les systèmes de la rangée arrière, de sorte que l'encombrement au sol de la centrale peut s'avérer non-optimisé. Il en est de même pour l'encombrement selon la direction verticale, en raison de la nécessité de prévoir des châssis suffisamment surélevés pour permettre d'implanter les réflecteurs au bas des panneaux solaires.

Enfin, cette conception ne permet pas au réflecteur de renvoyer la lumière selon une direction optimale sur la face arrière du système de devant, ce qui occasionne des pertes énergétiques ainsi qu'une hétérogénéité d'irradiation non-désirable.

### EXPOSE DE L'INVENTION

L'invention a donc pour but de remédier au moins partiellement aux inconvénients mentionnés ci-dessus, relatifs aux réalisations de l'art antérieur.

Pour ce faire, l'invention selon la revendication 1 a tout d'abord pour objet un système d'énergie solaire photovoltaïque comportant :
- une pluralité de cellules solaires photovoltaïques bifaciales, définissant conjointement une surface d'absorption directe ainsi qu'une surface d'absorption indirecte, les deux surfaces étant opposées et destinées à absorber une énergie de rayonnement solaire ;
- un châssis de support desdites cellules, ledit châssis comprenant une structure de support sur laquelle sont fixées les cellules.

Selon l'invention, ledit châssis comporte en outre un moyen de suspension de la structure de support, le moyen de suspension comprenant une extrémité haute raccordée à une première extrémité de la structure de support, et le moyen de suspension définissant une surface de réflexion configurée pour réfléchir la lumière en direction de ladite surface d'absorption indirecte définie par la pluralité de cellules.

L'invention contraste ainsi avec les réalisations antérieures essentiellement en ce qu'elle prévoit d'associer une fonction de réflecteur à au moins une partie du châssis. De par la conception proposée, le système se révèle avantageusement autonome. En effet, sa surface d'absorption indirecte est irradiée par la lumière qui se réfléchit sur la surface de réflexion du moyen de suspension, de sorte qu'elle n'a pas besoin de coopérer avec un autre système situé derrière elle. Par conséquent, non seulement le système peut être utilisé de manière autonome, mais en cas d'emploi dans une centrale à plusieurs rangées, la distance entre les rangées peut être fixée beaucoup plus librement que dans l'art antérieur décrit précédemment. C'est l'encombrement global de la centrale qui se trouve alors avantageusement réduit.

En outre, grâce à la fixation du moyen de suspension et de la structure de support au niveau de leurs extrémités, la totalité de la surface d'absorption indirecte, portée par la structure de support, peut ainsi être facilement éclairée et ce avec une direction optimale des rayons réfléchis. L'irradiation solaire des cellules devient ainsi maximale, et l'homogénéité d'éclairement entre les deux surfaces est largement améliorée.

Afin d'améliorer encore l'irradiation, selon l'invention, le châssis de support comporte en outre un réflecteur d'entrée dont une première extrémité est raccordée à une extrémité basse du moyen de suspension, le réflecteur d'entrée définissant une surface d'entrée de réflexion configurée pour réfléchir la lumière en direction de ladite surface de réflexion définie par le moyen de suspension. De plus, ladite surface d'absorption indirecte, la surface de réflexion, ainsi que la surface d'entrée de réflexion délimitent ensemble un espace de réflexion et de propagation de lumière ouvert entre une seconde extrémité du réflecteur d'entrée opposée à la première extrémité de ce réflecteur, et une seconde extrémité de la structure de support opposée à la première extrémité de cette structure.

L'invention prévoit également les caractéristiques optionnelles suivantes, prises isolément ou en combinaison.

Le châssis de support comporte un outre un dispositif de mise en mouvement permettant de faire pivoter l'ensemble formé par le moyen de suspension et la structure de support, et le dispositif de mise en mouvement comporte un bras télescopique dont une extrémité est articulée sur le réflecteur d'entrée. Cette particularité est adoptée afin de s'orienter au mieux par rapport au soleil, et ce à tout instant, avec un encombrement faible. Ce pivot s'effectue de préférence selon un axe de rotation sensiblement parallèle au sol, et sensiblement parallèle à une ligne de jonction entre la structure de support et le moyen de suspension.

Le réflecteur d'entrée, la structure de support ainsi que le moyen de suspension sont chacun de forme sensiblement plane, et ils présentent de préférence sensiblement la même largeur selon une direction de largeur L3 parallèle à des lignes de jonction entre ces trois éléments précités. Par ailleurs, les cellules sont également de préférence sensiblement planes.

De préférence, le réflecteur d'entrée est incliné d'un angle sensiblement égal à 90° par rapport au moyen de suspension, et ce dernier est incliné d'un angle sensiblement égal à 45° par rapport à la structure de support. Cette géométrie permet de faire en sorte que lorsque les rayons lumineux impactent perpendiculairement la surface d'absorption directe, les rayons réfléchis par le réflecteur et par le moyens de suspension impactent alors perpendiculairement la surface d'absorption indirecte. Cette direction d'impact occasionne un gain énergétique et renforce l'homogénéité d'irradiation de la surface d'absorption indirecte.

De préférence, le réflecteur d'entrée présente, entre ses première et seconde extrémités, une longueur « L1 » sensiblement identique à la longueur du moyen de suspension entre ses extrémités haute et basse, et la structure de support présente entre ses première et seconde extrémités une longueur « L2 » telle que la valeur du carré de L1 soit sensiblement égale à deux fois la valeur du carré de L2.

De préférence, ledit moyen de suspension définit également une surface de réflexion additionnelle, cette surface additionnelle étant préférentiellement opposée / adossée à ladite surface de réflexion. De cette manière, le moyen de suspension peut avantageusement renvoyer de la lumière en direction de la surface d'absorption directe d'un système situé en derrière.

Enfin, ledit moyen de suspension comprend au moins l'un des éléments suivants :
- une ossature sur laquelle est fixé un filet formant un élément de réflexion ;
- une ossature sur laquelle est fixée un ensemble de lamelles parallèles formant un élément de réflexion ;
- un ou plusieurs panneaux réflecteurs, par exemple traversés par des ouvertures équipées de moyens de récupération d'énergie éolienne.

L'invention a également pour objet une centrale solaire comprenant une pluralité de systèmes comme celui décrit ci-dessus, lesdits systèmes étant agencés de manière à former une pluralité de rangées.

D'autres avantages et caractéristiques de l'invention apparaîtront dans la description détaillée non limitative ci-dessous.

### BREVE DESCRIPTION DES DESSINS

Cette description sera faite au regard des dessins annexés parmi lesquels ;
- la figure 1 représente une vue de côté d'une centrale solaire, comprenant des rangées chacune formée par une pluralité de systèmes selon un mode de réalisation préféré de l'invention ;
- la figure 2 est une vue en perspective de l'un des systèmes montrés sur la figure précédente ;
- la figure 3 représente une vue de côté de celle de la figure précédente, schématisant le fonctionnement du système;
- la figure 4 représente une vue de côté de deux systèmes situés l'un devant l'autre, ces systèmes se présentant sous la forme d'un autre mode de réalisation préféré de l'invention ;
- la figure 5 représente une vue schématique de côté d'un système se présentant sous la forme encore d'un autre mode de réalisation préféré de l'invention ; et
- les figures 6a à 6c schématisent différentes réalisations possibles pour le moyen de suspension faisant partie intégrante des systèmes montrés sur les figures précédentes.

### EXPOSE DETAILLE DE MODES DE REALISATION PARTICULIERS

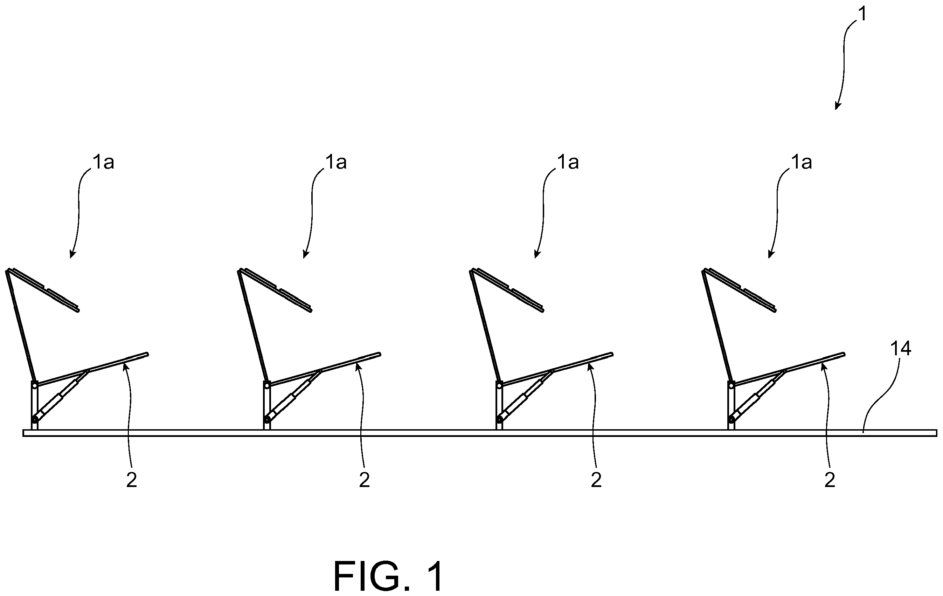

En référence tout d'abord à la figure 1, il est représenté une centrale solaire 1 présentant une pluralité de rangées la, de préférence parallèles entre elles, et comportant chacune plusieurs systèmes d'énergie solaire photovoltaïque 2 agencés côte-à-côte.

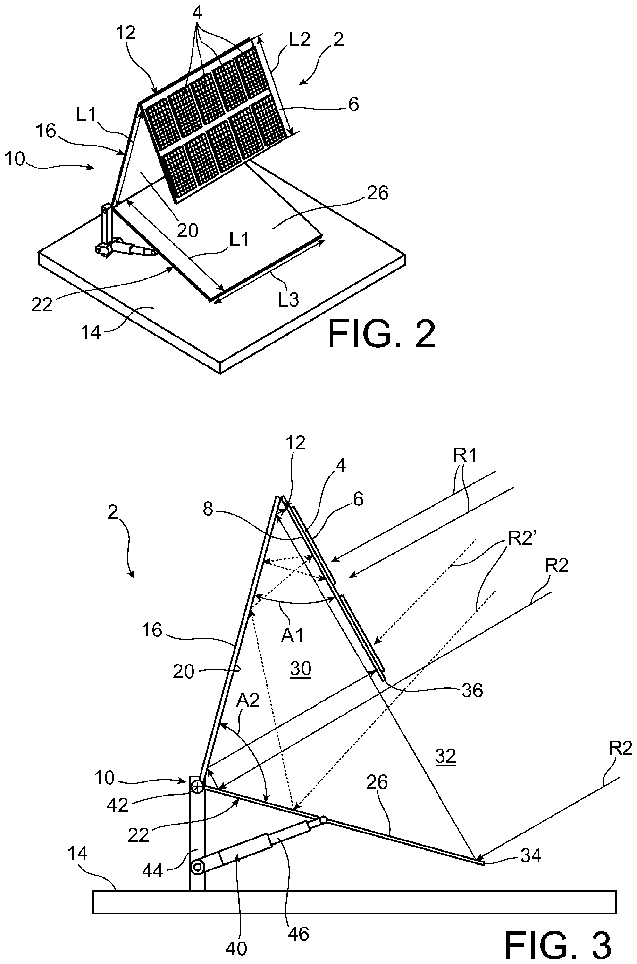

En référence aux figures 2 et 3, il est représenté l'un de ces systèmes 2, selon un mode de réalisation préféré de l'invention. A cet égard, il est noté que tous les systèmes de la centrale solaire sont identiques ou similaires. Ces systèmes sont fixés au sol 14, chacun à l'aide de leur châssis qui sera décrit ultérieurement. Dans d'autres applications, un ou plusieurs systèmes peuvent être utilisés afin d'être agencés sur une toiture d'un bâtiment.

Dans le mode de réalisation des figures 2 et 3, le système 2 comporte tout d'abord une pluralité de cellules solaires 4. Ces cellules solaires photovoltaïques sont de nature bifaciale, de manière à définir ensemble en face avant une surface d'absorption directe 6, ainsi qu'en face arrière une surface d'absorption indirecte 8. Ces deux surfaces 6, 8 sont conventionnellement sensiblement planes et parallèles entre elles, même si une autre réalisation pourrait être envisagée en prévoyant que ces deux surfaces ne soient pas parallèles entre elles. Les cellules solaires 4 peuvent être regroupées par panneaux, comme cela est visible en particulier sur la figure 2. Dans ce mode, il est en effet possible d'apercevoir dix panneaux équipant un même système 2. Ces panneaux sont agencés sensiblement dans un même plan, et tous supportés par un châssis 10 de support, spécifique à l'invention.

Tout d'abord, le châssis 10 comprend une structure de support 12 des cellules 4. Cette structure de support peut être réalisée de manière classique, par exemple à l'aide d'un cadre, éventuellement complétée par des éléments de renfort, tout en laissant subsister entre eux un espace suffisamment évidé pour permettre l'irradiation des deux surfaces 6, 8 par la lumière. La densité de cellules 4 est forte, puisque leur superficie cumulée correspond sensiblement à la superficie de la structure 12 telle que définie par sa périphérie.

Au niveau d'une première extrémité de cette structure de support 12, correspondant à une extrémité haute sensiblement parallèle au sol 14, le châssis comporte un moyen de suspension 16 destiné à suspendre la structure de support 12. Le moyen de suspension 16 est également de forme sensiblement plane. Son extrémité haute est raccordée mécaniquement à l'extrémité haute de la structure de support 12, de manière former une pliure entre les deux. L'angle A1 défini entre ces deux éléments 12, 16 est préférentiellement sensiblement égal à 45°, et plus généralement compris entre 30 et 60°.

L'une des particularités de la présente invention réside dans le fait que la surface du moyen de suspension qui est orientée en direction de la surface d'absorption indirecte 8, constitue une surface de réflexion 20 configurée pour réfléchir la lumière en direction de cette surface 8.

Il est également prévu un réflecteur d'entrée 22, dont une première extrémité est raccordée mécaniquement à une extrémité basse du moyen de suspension 16. Le réflecteur d'entrée 22 est également de forme sensiblement plane, et définit avec le moyen de suspension 16 un angle A2 sensiblement égal à 90°. Il présente une surface d'entrée de réflexion 26 configurée pour réfléchir la lumière en direction de la surface de réflexion 20 du moyen de suspension 16.

Le moyen de suspension 16, la structure de support 12, et le réflecteur d'entrée 22 s'étendent tous sur une largeur sensiblement identique, la direction de la largeur L3 étant ici considérée comme parallèle aux lignes de jonction entre ces trois éléments 12, 16, 22. D'autre part, la longueur L1 du réflecteur d'entrée 22, entre ces deux extrémités, et sensiblement identique à la longueur du moyen de suspension 16 entre son extrémité haute et son extrémité basse. De plus, entre ses première et seconde extrémités, la structure de support 12 présente une longueur L2 définie de telle sorte que le carré de la valeur L1 soit sensiblement égal à deux fois le carré de la valeur L2. Par conséquent, les trois surfaces 8, 20, 26 définissent ensemble un espace 30 de réflexion et de propagation de lumière, dont une ouverture 32 est délimitée entre une seconde extrémité 34 du réflecteur d'entrée 22, et la seconde extrémité 36 de la structure de support 12, considérée comme l'extrémité basse de cette structure.

L'ouverture 32 s'étend donc selon une longueur de demi-hypoténuse du triangle rectangle hypothétique formé par les éléments 12, 16, 22, l'autre demi-hypoténuse étend constituée par la structure de support 12.

Avec cette géométrie particulière du châssis 10, en vue de côté, des rayons lumineux R1 impactent sensiblement perpendiculairement la surface d'absorption directe 6. Cette orientation particulière est obtenue grâce à un dispositif de mise en mouvement 40 faisant partie intégrante du châssis 10, qui relie les éléments précédemment cités 12, 16, 22 au sol 14. Ce dispositif 40 permet une mise en rotation de ces éléments solidaires, selon un axe de rotation 42 sensiblement parallèle au sol 14 et sensiblement parallèle aux jonctions entre les éléments du châssis. De préférence, l'axe de rotation 42 se situe au niveau de la jonction entre le moyen de suspension 16 et le réflecteur d'entrée 22. Le dispositif 40 comporte par exemple un ou plusieurs bras verticaux 44 reliant le sol 14 à la jonction précitée, et comprend également un ou plusieurs bras télescopiques 46 dont une première extrémité est reliée sur les bras fixes 44, et dont une seconde extrémité est articulée sur le réflecteur d'entrée 22. Grâce à ce dispositif 40, il est en effet aisé de piloter l'orientation du châssis 10 afin que la surface d'absorption directe 6 soit à tout instant de la journée sensiblement perpendiculaire aux rayons R1. Ce dispositif 40 permet par exemple à l'ensemble d'effectuer un pivotement d'une amplitude totale de 30 à 60° autour de l'axe de rotation 42.

Bien que cela n'ait pas été représenté, le châssis pourrait également comporter un dispositif tournant selon un axe vertical, afin de suivre l'azimut du soleil.

En outre, des rayons lumineux R2 pénètrent à travers l'ouverture 32 dans l'espace 30, comme cela est schématisé sur la figure 3. Ces rayons R2 se réfléchissent sur la surface de réflexion d'entrée 26, puis sur la surface de réflexion 20, avant d'aller impacter sensiblement perpendiculairement la surface d'absorption indirecte 8, sur toute la surface de celle-ci. Dans le cas où le châssis 10 ne pourrait pas être orienté pour amener les rayons R2 perpendiculairement à la surface 8 en vue de côté, par exemple en cas d'absence du dispositif de mise en mouvement 40, les rayons R'2 représentés en pointillés sur la figure 3 seraient tout de même piégés dans l'espace 30 après avoir emprunté l'ouverture 32. Il se produit dans ce cas un effet de rebonds propice à une irradiation satisfaisante de la surface d'absorption indirecte 8.

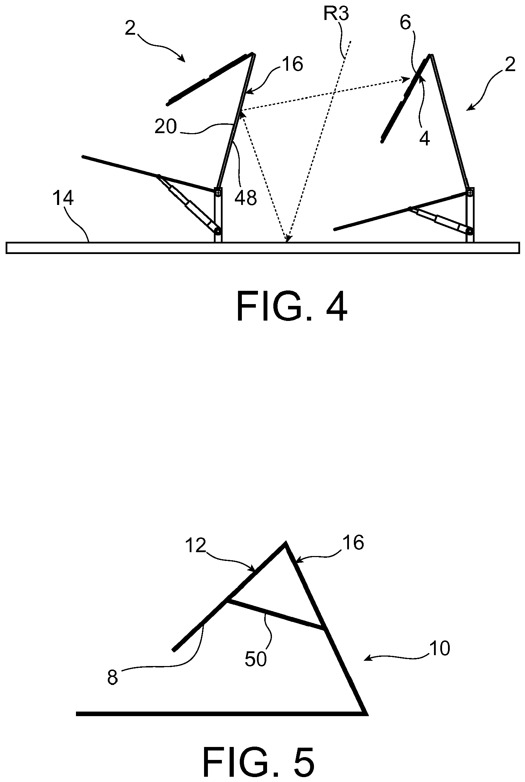

Selon un autre mode de réalisation montré sur la figure 4, le moyen de suspension 16 présente, à l'opposé de sa surface de réflexion 20, une surface de réflexion additionnelle 48 dont la fonction consiste à irradier la surface d'absorption directe 6 d'un autre système situé en arrière. En effet, des rayons lumineux R3 impactent le sol 14 entre deux systèmes 2, puis se réfléchissent d'abord sur la surface de réflexion additionnelle 48 à l'arrière du moyen de suspension 16 du système avant, pour ensuite impacter la surface d'absorption directe 6 des cellules du système arrière. Le gain de la centrale solaire s'en trouve avantageusement augmenté.

La figure 5 montre un mode de réalisation dans lequel une ou plusieurs barres de renfort 50 peuvent venir compléter le châssis 10, en reliant le moyen de suspension 16 à la structure de support 12. Cependant, leur nombre et leur section restent limités, afin de ne pas trop restreindre l'étendue de l'irradiation de la surface d'absorption indirecte 8.

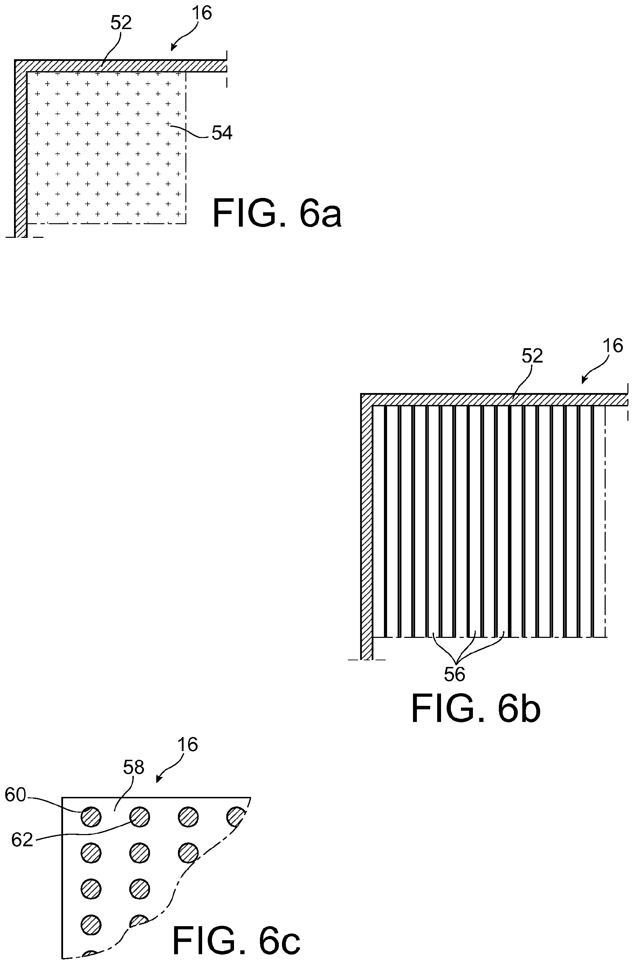

Enfin, les figures 6a à 6c montrent différentes possibilités pour réaliser le moyen de suspension 16. Selon une première réalisation montrée sur la figure 6a, il est prévu une ossature 52 formant la périphérie du moyen 16. A cette ossature, il est fixé un filet 54 qui présente donc des ouvertures afin de laisser passer le vent, réduisant ainsi l'effort de pression s'appliquant sur le moyen de suspension 16. Dans l'exemple montré, il s'agit d'un filet de camouflage couramment employé dans le domaine militaire, de préférence de couleur blanche afin de favoriser la réflexion optique.

Selon une autre réalisation montrée sur la figure 6b, l'ossature 52 porte des lamelles parallèles 56 qui forment des éléments de réflexion. Ici encore, les espaces prévus entre les lamelles permettent au vent de traverser le moyen 16 sans exercer d'efforts de pression trop importants. Ces lamelles 56, assimilables à un store californien, peuvent être réalisées à l'aide d'un composite polymère blanc, comme par exemple des produits commercialisés par la société Dupont® sous les appellations TPT® ou Tedlar®.

En alternative, le moyen de suspension 16 pourrait être plein, et conçu pour résister à l'effort de pression résultant du vent. Cependant, une troisième réalisation améliorée consiste à prévoir un ou plusieurs panneaux réflecteurs 58, de nature structurale ou rapportés sur une ossature, comme montré sur la figure 6c. Chaque panneau 58 comporterait alors plusieurs ouvertures 60 équipées de moyens de récupération d'énergie éolienne, comme des mini-éoliennes 62 représentées uniquement schématiquement sur la figure 6c.

## Revendications

1. Système d'énergie solaire photovoltaïque (2) comportant :
- une pluralité de cellules solaires photovoltaïques bifaciales (4), définissant conjointement une surface d'absorption directe (6) ainsi qu'une surface d'absorption indirecte (8), les deux surfaces étant opposées et destinées à absorber une énergie de rayonnement solaire ;
- un châssis (10) de support desdites cellules, ledit châssis comprenant une structure de support (12) sur laquelle sont fixées les cellules (4),
**caractérisé en ce que** ledit châssis (10) comporte en outre un moyen (16) de suspension de la structure de support (12), le moyen de suspension (16) comprenant une extrémité haute raccordée à une première extrémité de la structure de support, et **en ce que** le moyen de suspension (16) définit une surface de réflexion (20) configurée pour réfléchir la lumière en direction de ladite surface d'absorption indirecte (8) définie par la pluralité de cellules (4),
et **en ce que** le châssis de support (10) comporte en outre un réflecteur d'entrée (22) dont une première extrémité est raccordée à une extrémité basse du moyen de suspension (16), le réflecteur d'entrée (22) définissant une surface d'entrée de réflexion (26) configurée pour réfléchir la lumière en direction de ladite surface de réflexion (20) définie par le moyen de suspension (16), et **en ce que** ladite surface d'absorption indirecte (8), la surface de réflexion (20), ainsi que la surface d'entrée de réflexion (26) délimitent ensemble un espace (30) de réflexion et de propagation de lumière ouvert entre une seconde extrémité (34) du réflecteur d'entrée opposée à la première extrémité de ce réflecteur, et une seconde extrémité (36) de la structure de support opposée à la première extrémité de cette structure.

2. Système selon la revendication 1, **caractérisé en ce que** le châssis de support (10) comporte un outre un dispositif (40) de mise en mouvement permettant de faire pivoter l'ensemble formé par le moyen de suspension (16) et la structure de support (12), et **en ce que** le dispositif de mise en mouvement (40) comporte un bras télescopique (46) dont une extrémité est articulée sur le réflecteur d'entrée (22).

3. Système selon la revendication 1 ou 2, **caractérisé en ce que** le réflecteur d'entrée (22), la structure de support (12) ainsi que le moyen de suspension (16) sont chacun de forme sensiblement plane, et **en ce qu'**ils présentent de préférence sensiblement la même largeur selon une direction de largeur (L3) parallèle à des lignes de jonction entre ces trois éléments (12, 16, 22).

4. Système selon l'une quelconque des revendications précédentes, **caractérisé en ce que** le réflecteur d'entrée (22) est incliné d'un angle (A2) sensiblement égal à 90° par rapport au moyen de suspension (16), et **en ce que** ce dernier est incliné d'un angle (A1) sensiblement égal à 45° par rapport à la structure de support (12).

5. Système selon la revendication 4, **caractérisé en ce que** le réflecteur d'entrée (22) présente, entre ses première et seconde extrémités, une longueur « L1 » sensiblement identique à la longueur du moyen de suspension (16) entre ses extrémités haute et basse, et **en ce que** la structure de support (12) présente entre ses première et seconde extrémités une longueur « L2 » telle que la valeur du carré de L1 soit sensiblement égale à deux fois la valeur du carré de L2.

6. Système selon l'une quelconque des revendications précédentes, **caractérisé en ce que** ledit moyen de suspension (16) définit également une surface de réflexion additionnelle (48).

7. Système selon l'une quelconque des revendications précédentes, **caractérisé en ce que** ledit moyen de suspension (16) comprend au moins l'un des éléments suivants :
- une ossature (52) sur laquelle est fixé un filet (54) formant un élément de réflexion ;
- une ossature (52) sur laquelle est fixée un ensemble de lamelles parallèles (56) formant un élément de réflexion ;
- un ou plusieurs panneaux réflecteurs (58), par exemple traversés par des ouvertures (60) équipées de moyens de récupération d'énergie éolienne (62).

8. Centrale solaire (1) comprenant une pluralité de systèmes (2) selon l'une quelconque des revendications précédentes, lesdits systèmes étant agencés de manière à former une pluralité de rangées (1a).

## Patentansprüche

1. Photovoltaik-Solaranlage (2) umfassend:
- mehrere zweiseitige Photovoltaik-Solarzellen (4), die gemeinsam eine direkte Absorptionsfläche (6) und eine indirekte Absorptionsfläche (8) definieren, wobei die beiden Flächen einander gegenüberliegen und dazu bestimmt sind, Energie aus Sonnenstrahlung zu absorbieren;
- einen Stützrahmen (10) für die Zellen, wobei der Rahmen eine Stützstruktur (12) umfasst, an der die Zellen (4) befestigt sind,
**dadurch gekennzeichnet, dass** der Rahmen (10) ferner ein Aufhängungsmittel (16) für die Stützstruktur (12) umfasst, wobei das Aufhängungsmittel (16) ein oberes Ende umfasst, das mit einem ersten Ende der Stützstruktur verbunden ist, und dass das Aufhängungsmittel (16) eine Reflexionsfläche (20) definiert, die dazu konfiguriert ist, das Licht in Richtung der indirekten Absorptionsfläche (8) zu reflektieren, die durch die mehreren Zellen (4) definiert ist,
und dadurch, dass der Stützrahmen (10) weiter einen Einlassreflektor (22) umfasst, dessen eines erstes Ende mit einem unteren Ende des Aufhängungsmittels (16) verbunden ist, wobei der Einlassreflektor (22) eine Reflexionseintrittsfläche (26) definiert, die konfiguriert ist, um das Licht in Richtung der Reflexionsfläche (20) zu reflektieren, die durch das Aufhängungsmittel (16) definiert ist, und dass die indirekte Absorptionsfläche (8), die Reflexionsfläche (20) sowie die Reflexionseintrittsfläche (26) zusammen einen Raum (30) für Reflexion und Ausbreitung von Licht begrenzen, der zwischen einem zweiten Ende (34) des Einlassreflektors, das dem ersten Ende dieses Reflektors gegenüberliegt, und einem zweiten Ende (36) der Stützstruktur, das dem ersten Ende dieser Struktur gegenüberliegt, offen ist.

2. System nach Anspruch 1, **dadurch gekennzeichnet, dass** der Stützrahmen (10) ferner eine Bewegungsantriebsvorrichtung (40) umfasst, die es ermöglicht, die durch das Aufhängungsmittel (16) und die Stützstruktur (12) gebildete Anordnung zum Schwenken zu bringen, und dadurch, dass die Bewegungsantriebsvorrichtung (40) einen Teleskoparm (46) umfasst, von dem ein Ende am Einlassreflektor (22) angelenkt ist.

3. System nach Anspruch 1 oder 2, **dadurch gekennzeichnet, dass** der Einlassreflektor (22), die Stützstruktur (12) sowie das Aufhängungsmittel (16) jeweils im Wesentlichen flach ausgebildet sind, und dass sie vorzugsweise im Wesentlichen die gleiche Breite in einer Breitenrichtung (L3) parallel zu den Verbindungslinien zwischen diesen drei Elementen (12, 16, 22) aufweisen.

4. System nach einem der vorhergehenden Ansprüche, **gekennzeichnet dadurch, dass** der Einlassreflektor (22) unter einem Winkel (A2) von im Wesentlichen gleich 90° relativ zu dem Aufhängungsmittel (16) geneigt ist, und dass letzteres relativ zur Stützstruktur (12) unter einem Winkel (A1) geneigt ist, der im Wesentlichen gleich 45° ist.

5. System nach Anspruch 4, **dadurch gekennzeichnet, dass** der Einlassreflektor (22) zwischen seinem ersten und zweiten Ende eine Länge "L1" aufweist, die im Wesentlichen identisch zu der Länge des Aufhängungsmittels (16) zwischen seinem oberen und unteren Ende ist, und dadurch, dass die Stützstruktur (12) zwischen ihrem ersten und zweiten Ende eine Länge "L2" aufweist, so dass der Wert des Quadrats von L1 im Wesentlichen gleich dem doppelten Wert des Quadrats von L2 ist.

6. System nach einem der vorhergehenden Ansprüche, **dadurch gekennzeichnet, dass** das Aufhängungsmittel (16) auch eine zusätzliche Reflexionsfläche (48) definiert.

7. System nach einem der vorhergehenden Ansprüche, **dadurch gekennzeichnet, dass** das Aufhängungsmittel (16) mindestens eines der folgenden Elemente umfasst:
- ein Gerüst (52), an dem ein Netz (54) befestigt ist, das ein Reflexionselement bildet;
- ein Gerüst (52), an dem ein Satz paralleler Lamellen (56) befestigt ist, die ein Reflexionselement bilden;
- ein oder mehrere reflektierende Paneele (58), die beispielsweise von Öffnungen (60) durchsetzt sind, die mit Windenergie-Rückgewinnungsmitteln (62) ausgestattet sind.

8. Solaranlage (1), umfassend mehrere Systeme (2) gemäß einem der vorhergehenden Ansprüche, wobei die Systeme so angeordnet sind, dass sie mehrere Reihen (1a) bilden.

## Claims

1. A photovoltaic solar energy system (2) including:
- a plurality of bifacial photovoltaic solar cells (4), defining together a direct absorption surface (6) as well as an indirect absorption surface (8), both surfaces being opposite and intended to absorb a solar radiation energy;
- a support chassis (10) for supporting said cells, said chassis comprising a support structure (12) on which the cells (4) are attached,
**characterised in that** said chassis (10) further includes a suspension means (16) for suspending the support structure (12), the suspension means (16) comprising a top end connected to a first end of the support structure, and **in that** the suspension means (16) defines a reflective surface (20) configured to reflect light towards said indirect absorption surface (8) defined by the plurality of cells (4),
and **in that** the support chassis (10) further includes an input reflector (22) a first end of which is connected to a bottom end of the suspension means (16), the input reflector (22) defining a reflective input surface (26) configured to reflect light towards said reflective surface (20) defined by the suspension means (16), and **in that** said indirect absorption surface (8), the reflective surface (20), as well as the reflective input surface (26) delimit together a light reflection and propagation space (30) open between a second end (34) of the input reflector opposite to the first end of this reflector, and a second end (36) of the support structure opposite to the first end of this structure.

2. The system according to claim 1, **characterised in that** the support chassis (10) further includes a moving device (40) for pivoting the whole formed by the suspension means (16) and the support structure (12), and **in that** the moving device (40) includes a telescopic arm (46) one end of which is hinged to the input reflector (22).

3. The system according to claim 1 or 2, **characterised in that** the input reflector (22), the support structure (12) as well as the suspension means (16) are each of a substantially planar shape, and **in that** they preferably substantially have the same width along a width direction (L3) parallel to junction lines between these three elements (12, 16, 22).

4. The system according to any preceeding claims, **characterised in that** the input reflector (22) is tilted by an angle (A2) substantially equal to 90° with respect to the suspension means (16), and **in that** the latter is tilted by an angle (A1) substantially equal to 45° with respect to the support structure (12).

5. The system according to claim 4, **characterised in that** the input reflector (22) has, between its first and second ends, a length "L1" substantially identical to the length of the suspension means (16) between its top and bottom ends, and **in that** the support structure (12) has between its first and second ends a length "L2" such that the L1 squared value is substantially equal to twice the L2 squared value.

6. The system according to claim 1, **characterised in that** said suspension means (16) also defines an additional reflective surface (48).

7. The system according to any preceeding claims, **characterised in that** said suspension means (16) comprises at least one of the following elements:
- a framework (52) on which a net (54) forming a reflective element is attached;
- a framework (52) on which a set of parallel lamellae (56) forming a reflective element is attached;
- one or more reflective panels (58), for example through which apertures (60) equipped with wind energy recovering means (62) pass.

8. A solar power plant (1) comprising a plurality of systems (2) according to any preceeding claims, said systems being arranged so as to form a plurality of rows (1a).
